# EUROPEAN PATENT APPLICATION

(11) **EP 4 481 816 A1**
(43) Date of publication of application: **25.12.2024**
(21) Application number: 23753254.4
(22) Date of filing: 14.02.2023
(51) Int. Cl.: H01L 25/16, H01L 23/538

(54) **OPTICAL SYSTEM-IN-PACKAGE, AND OPTICAL MODULE AND OPTICAL TRANSCEIVER USING SAME**

(30) Priority: 14.02.2022 KR 20220018846
(71) Applicant: Lipac Co., Ltd., Seoul 07281 (KR)
(72) Inventor: CHOI, Seong Wook, Seoul 07281 (KR)
(74) Representative: Lambacher, Michael
(86) International application number: PCT/KR2023/002105
(87) International publication number: WO 2023/153908

(57) **Abstract**

Provided are an optical system-in-package (O-SIP) including a photonic integrated circuit (IC), an electronic IC, and the like, in a package, and an optical module and an optical transceiver using an O-SIP. The O-SIP includes: a mold body having a first surface and a second surface, which are flat, in a lower portion and an upper portion of the mold body, respectively; a photonic IC molded inside the mold body to expose a bonding pad on the second surface; an electronic IC molded to be spaced apart from the photonic IC inside the mold body to expose the bonding pad on the second surface; and a redistribution layer (RDL) formed on the second surface of the mold body and having a plurality of fan-out terminal pads electrically connected to the outside while interconnecting the photonic IC and the electronic IC.

## Description

### TECHNICAL FIELD

The present invention relates to an optical system-in-package (O-SIP), and more specifically, to an optical system-in-package (O-SIP) including photonic integrated circuits (ICs) and electronic ICs in the package, and an optical module and an optical transceiver using the same.

### BACKGROUND ART

Semiconductor chips may be used to manufacture light receiving devices capable of reacting to light or light emitting devices emitting light, as well as serving as a logic or driving IC. These optical devices are used in various fields, such as optical transceivers in charge of optical connections between servers, or optical modules that transmit image data between TVs and set-top boxes, or between virtual reality (VR) glasses and graphics processing units (GPUs).

Further, other applications of the optical devices may be used in a proximity sensor, a time of flight (TOF) sensor, a light detection and ranging (LIDAR) device, and the like, which include a light emitting device.

Optical devices should be used together with electronic devices that drive or interface the optical devices, thereby converting optical signals into electronic signals. For example, in the field of transmitting optical data, an optical device and an electronic device may be used together for a module for converting an optical signal into a digital signal. As another example, in the optical sensor field, a device for converting characteristics of received light into image data or depth data may be used together with an optical device.

In all of the above conventional applications, a plurality of chips are mounted using a printed circuit board (PCB) in which a wiring pattern is mostly manufactured and connected by wire-bonding. This is a chip-on-board (CoB) type package.

In addition, instead of a package using a PCB, an optical/electric device may be packaged at a wafer level using a semiconductor package method based on a fan out wafer level package (FOWLP) process, which is a technology that may increase performance by using a high-precision redistribution layer (RDL) while producing an ultra-thin package.

When the optical/electric package is performed using the semiconductor package, most of optical paths may be perpendicular to light emitting device chips, so that the optical paths may be arranged on one surface of the package, and a terminal pad for electrical connection with the outside may be formed on the opposite surface of the package. In addition, the redistribution layer for connecting between chips molded therein is arranged on one surface of the optical/electric package having the optical path.

### DISCLOSURE

### TECHNICAL PROBLEM

A task of the present invention is to solve a problem of having to form a conductive via through a package for connection with a fan-out terminal pad arranged on a second surface opposite to a first surface of the package because the fan-out terminal pad is arranged on the opposite surface of the package when performing an optical/electric package by using a semiconductor package.

In order to include a conductive via in a package, an additional process or a method of packaging a PCB on which the conductive via is formed or a conductive via structure together, is used in a semiconductor packaging operation. The generation of the conductive via has a disadvantage in that a material cost or a process cost increases.

Furthermore, because the RDL and the terminal pad that interconnect molded chips inside the package are located opposite to each other in a package using the conductive via, the terminal pad may only be arranged in the form of a fan-out and may not be arranged in the form of a fan-in unless wiring layers inside the package are manufactured on both sides of the terminal pad. When terminal pads are arranged only in the form of a fan-out, while excluding the arrangement of terminal pads in the form of a Fan-In including an area where a chip is located, the advantage of integration is lost due to an increase in an area of the package.

Therefore, in order to solve the problem of not being able to arrange the terminal pads in the Fan-In form, RDLs may be formed on both sides of the package to produce fan-in and fan-out type pads, but this causes an increase in a process cost. In particular, since efforts should be made to precisely align the RDL patterns placed on both sides of the package, this increases the cost rather than simply increasing the RDL placed on one side. In addition, when the RDLs are formed on both sides of the package, a heat transfer path may be hindered when a molded chip is radiated through a lower part of the package due to the addition of the RDL at the lower part of the package.

In addition, it is very important to design a heat dissipation structure when using an optical chip. This is because a lot of heat is not only generated in the optical chip, but the light emitting conditions or light receiving conditions of the optical chip are also often temperature-sensitive. Thus, heat dissipation design is a very important part. In all of the existing package methods of using CoB or semiconductor packaging, if a heat dissipation structure (a structure connected to a heat sink or metal housing) is placed on a light emitting surface of the package, the optical path is hidden by the heat dissipation structure and thus, the heat dissipation structure is generally placed on the other side of the light emitting surface of the package.

Therefore, most of the heat dissipation path consists of a surface where the terminal pad of the package is located, and in this case, since the surface where the terminal pad of the package is formed is connected to a main PCB of an optical transceiver, most of the heat dissipation of the package occurs through a thermal via of the main PCB. Therefore, the conventional method has a problem in that the heat dissipation path between the heat dissipation structure and the chip is interrupted by the PCB.

In the present invention, in order to solve the above-described problems, an optical system-in-package (O-SIP) including a photonic IC and an electronic IC in a package, and an optical module and an optical transceiver using the same, may be provided.

In addition, in this invention, an optical module obtained by combining an O-SIP provided with both a light emitting device and a light receiving device to a main board (or a main PCB) or a module board (or a module PCB) may be combined with a case with an infrared radiation (IR) window to provide a simple and slim proximity sensor.

### TECHNICAL SOLUTION

In accordance with an aspect of the present invention, there is provided an optical system-in-package (O-SIP) including: a mold body having a first surface and a second surface which are flat on a lower portion and an upper portion of the mold body, respectively; a photonic integrated circuit (IC) molded inside the mold body to expose a bonding pad on the second surface; an electronic IC molded to be spaced apart from the photonic IC inside the mold body to expose the bonding pad on the second surface; and a redistribution layer (RDL) formed on the second surface of the mold body and having a plurality of fan-out terminal pads electrically connected to the outside while interconnecting the photonic IC and the electronic IC.

The photonic IC may include at least one of a light emitting device, a light receiving device, a chip that provides an additional function to the light emitting device or the light receiving device or is in charge of signal processing, and a planar lightwave circuit (PLC).

In addition, the electronic IC may include one of a driving circuit for driving the light emitting device, a circuit that receives and amplifies and/or converts an electrical signal from the light receiving device, a laser diode (LD) driver IC, a clock data recovery (CDR), an equalizer, a transimpedance amplifier (TIA), an inter-integrated circuit (I2C) communication, and a digital signal processing (DSP).

The O-SIP according to an embodiment of the present invention may further include first and second metal structures for heat dissipation in which upper surfaces of the first and second metal structures are bonded to lower portions of the photonic IC and the electronic IC and lower surfaces thereof are exposed, respectively.

The O-SIP according to an embodiment of the present invention may further include: a third metal structure for a via that is inserted through the mold body between the photonic IC and the electronic IC, has an upper end connected to the RDL and a lower end portion exposed; and a metal connection layer that connects the RDL to the lower portions of the photonic IC and the electronic IC and has a lower surface of the metal connection layer exposed by interconnecting the lower surfaces of the first to third metal structures.

The O-SIP according to an embodiment of the present invention may further include a thermal interface material (TIM) installed on a lower portion of the metal connection layer to form a heat dissipation path to a metal housing of the main body.

A transmitter optical sub-assembly (TOSA) to which a light emitting device is applied as the photonic IC and a receiver optical sub-assembly (ROSA) to which a light receiving device is applied as the photonic IC are formed in the O-SIP.

In addition, the photonic IC may include a light entrance/exit part on the second surface, and may further include a metasurface that serves as a microlens or a metalens formed through a microelectro mechanical system (MEMS) or an imprint process on the RDL located above the light entrance/exit part.

According to another aspect of an embodiment of the present invention, there is provided an optical module including: an optical system-in-package (O-SIP) for generating an optical signal or receiving an optical signal, in which a photonic integrated circuit (IC) and an electronic IC for driving or interfacing the photonic IC are molded inside a mold body having a first surface and a second surface which are flat, on a lower portion and an upper portion of the mold body; and a printed circuit board (PCB) in which the O-SIP is mounted on a lower surface of the PCB and multiple electronic components are mounted on an upper surface thereof to control transmission and reception of the O-SIP, wherein the PCB includes a through hole forming an optical path when generating or receiving an optical signal in a vertical direction from or to the photonic IC in a portion corresponding to a light entrance/exit part of the photonic IC.

The optical module according to an embodiment of the present invention may further include a redistribution layer (RDL) in which a plurality of fan-out terminal pads are arranged to electrically connect the photonic IC and the electronic IC to the outside while interconnecting the photonic IC and the electronic IC on the second surface on which a light entrance/exit part of the photonic IC is arranged.

The optical module according to an embodiment of the present invention further includes an optical component positioned above the through hole of the PCB to bend the optical path 90 degrees from vertically to horizontally to transmit the optical signal between an optical fiber and the photonic IC, and the optical component may be connected to an optical cable connector including a LC receptacle through the optical fiber.

According to another aspect of an embodiment of the present invention, there is provided an optical module including: an optical system-in-package (O-SIP) for generating an optical signal or receiving an optical signal, in which a photonic integrated circuit (IC) and an electronic IC for driving or interfacing the photonic IC are molded inside a mold body having a first surface and a second surface which are flat, on a lower portion and an upper portion of the mold body; a printed circuit board (PCB) in which the O-SIP is mounted on a lower surface of the PCB, multiple electronic components are mounted on an upper surface thereof to control transmission and reception of the O-SIP, and a slot-shaped coupling groove is provided on a side surface thereof; and an arrayed waveguide grating (AWG), including a tip portion having an inclined surface, which is coupled with an end portion of the coupling groove, the AWG performing, when optical signals of a plurality of channels generated from the photonic IC are received, a wavelength division multiplexing (WDM) function to transmit the received optical signals to an optical fiber or de-multiplexing optical signals received from the optical fiber to transmit the de-multiplexed optical signals to the photonic IC through the inclined surface.

The rear end portion of the AWG may be connected to an optical cable connector including a Lucent connector (LC) receptacle through a ferrule and the optical fiber.

In this case, the O-SIP may include the mold body having a first surface and a second surface, which are flat on a lower portion and an upper portion of the mold body, respectively; the photonic integrated circuit (IC) molded inside the mold body to expose a bonding pad on the first surface; the electronic IC molded to be spaced apart from the photonic IC inside the mold body to expose the bonding pad on the first surface; and a redistribution layer (RDL) formed on the second surface of the mold body and having a plurality of fan-out terminal pads electrically connected to the outside while interconnecting the photonic IC and the electronic IC.

According to another aspect of an embodiment of the present invention, there is provided an optical transceiver including an optical module and a housing accommodating the optical module.

In order to solve the problems existing in an optical package manufactured using a conductive via in a fan out wafer level package (FOWLP), the present invention provides an optical system-in-package (O-SIP), and an optical module and an optical transceiver using the O-SIP in which a photonic integrated circuit (IC) and an electronic IC are included in a package by using an optical FOWLP that does not use a conductive via. The O-SIP may include an optical engine module.

The photonic IC and the electronic IC may be molded in a package, and an exposed surface of an IC having a terminal pad and a light entrance/exit part may be molded to face a redistribution layer (RDL). The RDL may be arranged on the mold, and an external connection terminal pad may be arranged on the RDL. A microlens, an optical system, a metasurface, or a layer having various patterns may be manufactured at a wafer level through an additional micro electro mechanical system (MEMS) or imprint process on the RDL.

In the related art, glass is used as a lens to refract light to sharpen an image or to amplify the image. However, a metasurface serving as a metalens may have a structure such as a nano-sized column or pin, thereby concentrating light without image distortion.

When packaging is performed in the above-described FOWLP form, for example, when a surface mount technology (SMT) is applied to a main PCB in which an optical transceiver is embedded, the light entrance/exit part may be blocked due to the main PCB. To solve this problem, according to the present invention, it is possible to solve the problem by manufacturing a light entrance/exit part by making a through hole or using a transparent material in the main PCB. Thereafter, optical components such as necessary lenses and optical fibers may be assembled on the main PCB.

Furthermore, in the present invention, metal structures which are molded for the heat dissipation of the photonic IC and the electronic IC, may be arranged below the photonic IC and the electronic IC. The surfaces of the metal structures are opened to expose the metal structures on the opposite surface of the package facing the RDL of the FOWLP, and the exposed surfaces of the metal structures are connected to heat dissipation structures such as a heat sink or a thermal interface material (TIM) to form a heat dissipation path.

In addition, in order to electrically connect the lower portions of the photonic IC and the electronic IC, the metal structures may be connected to the RDL located on the upper surface of the FOWLP. In this case, a metal may be deposited on the entire lower surface of the FOWLP at a wafer level to form a metal connection layer, and then the metal structure and the RDL of the FOWLP may be connected to the conductive via or the metal structures may be electrically connected therebetween by the metal connection layer.

Furthermore, in the O-SIP of the present invention, the photonic IC is an integrated circuit that performs optical processing, and converts an optical signal into an electrical signal or converts an electrical signal into an optical signal. For example, the photonic IC 130 may be a chip, which includes light emitting devices such as vertical-cavity surface-emitting lasers (VCSEL) and laser diodes (LD), or photodiodes (PD), avalanche photodiodes (APD), a complementary metal oxide semiconductor (CMOS) image sensor (CIS), a charge coupled device (CCD) image sensor, and a time-of-flight (ToF) sensor, in which a plurality of photodiodes (PD) are arranged in an array, and additionally includes a circuit that provides the CIS, the CCD image sensor, and the ToF sensor with an additional function or is in charge of signal processing.

In addition, the photonic IC may be manufactured by processing a Si substrate based on a CMOS fabrication process, and may also employ a silicon photonics (SiPh) in which laser diodes (LD) capable of generating laser beams and gratings are embedded. The SiPh may generate a laser in a direction perpendicular to one surface of the chip from the gratings.

The APD is a photodiode (PD) having an optical current amplification mechanism therein, and may be widely used as an optical detector in optical transmission.

In addition, the electronic IC is used to operate according to the photonic IC. For example, when the photonic IC is a photodiode, the electronic IC may operate together with a transimpedance amplifier for amplifying an electrical signal due to a collision of photons on the photodiode. When the photonic IC is a light emitting device, the electronic IC may use a driving circuit for driving the light emitting device.

Furthermore, the O-SIP of the present invention may use, instead of the electronic IC, a chip that includes a PD, an APD, a CIS, a CCD image sensor, and a ToF sensor, and additionally includes a signal processing device as a circuit or an IC for providing the PD, APD, CIS, CCD image sensor, and ToF sensor with additional functions or being in charge of processing signals.

In addition, the O-SIP of the present invention may include the photonic IC which includes all of light emitting devices such as vertical-cavity surface-emitting lasers (VCSEL) and laser diodes (LD), or light receiving devices such as photodiodes (PD), avalanche photodiodes (APD), a complementary metal oxide semiconductor (CMOS) image sensor (CIS), a charge coupled device (CCD) image sensor, and a time-of-flight (ToF) sensor, in which a plurality of photodiodes (PD) are arranged in an array, and an electronic IC 140 for driving the photonic IC 130.

The present invention provides an O-SIP in which a plurality of photonic ICs and electronic ICs are located inside a package formed in an SIP form without using a separate substrate, and an optical path between the photonic IC and the outside of the SIP is formed. The O-SIP of the present invention enables smaller and inexpensive optical transceivers as the substrate usage is excluded.

In the present invention, a slim O-SIP may be implemented by packaging the photonic IC and the electronic IC by using a fan-out technology of pulling out input/output (I/O) terminals thereby increasing the I/O terminals, that is, a Fan-Out Wafer Level Package (FOWLP) technology, when the electronic IC (such as a chip) operating according to the photonic IC is integrated, without wire-bonding, by using a flip chip package technology together with the photonic IC, while devices are integrated without using a substrate.

In order to fix a chip (die) without using a substrate such as a PCB, the O-SIP, which is a kind of SIP technology, may miniaturize and slim at a level of 1/16 or so compared to a conventional package by packaging using an encapsulation material such as an epoxy mold compound (EMC) and reduce costs.

The optical module obtained by coupling the O-SIP according to the present invention to the main board (that is, the main PCB) or the module board (that is, the module PCB) may not only form a slim structure but also perform heat dissipation through a heat sink or a main body housing made of a metal through a dissipation metal structure attached to the rear surface of the O-SIP instead of the main board (that is, the main PCB), thereby preventing performance degradation.

An optical proximity sensor using infrared reflection light reflected from a target after the IR light is emitted according to the present invention includes: an optical system-in-package (O-SIP) in which a light emitting device emitting infrared (IR) light and a proximity sensor IC having a light receiving device embedded therein while driving the light emitting device, and having a light receiving function, the light emitting device and the proximity sensor IC being molded in a mold body; and a printed circuit board (PCB) having a through hole for forming a path of light at portions corresponding to light entrance/exit parts of the light emitting device and the light receiving device when the O-SIP is mounted on a lower surface of the PCB, wherein the optical proximity sensor may be coupled to a portion of the main body housing and corresponding to the through hole by being coupled to a portion where an IR window is formed.

According to this invention, an optical module obtained by combining an O-SIP provided with both a light emitting device and a light receiving device to a main board (or a main PCB) or a module board (or a module PCB) may be combined with a case with an infrared radiation (IR) window to provide a simple and slim proximity sensor.

### ADVANTAGEOUS EFFECTS

As described above, the present invention may solve the problem of a cost increase, the inefficiency of arrangement of a terminal pad, and the deterioration of the heat dissipation performance, which are due to the use of an existing conductive via pointed to as the disadvantage of the FOWLP using the existing conductive via.

In addition, in this invention, arrangement of the Fan-in and Fan-out terminal pads may be used simultaneously, thereby efficiently arranging terminal pads, and as a result, the package size may be reduced when the terminal pad may be further integrated, thereby achieving miniaturization of products and reduction of a process cost.

Moreover, in this invention, it is possible to manufacture a package that exhibits superior heat dissipation performance than an optical package product through a FOWLP using a conventional CoB method and an existing conductive via.

In addition, in the case of using the O-SIP structure of this invention, an optical module with the minimum thickness may be manufactured for each application as described in the following examples.

The optical module obtained by coupling the O-SIP according to the present invention to the main board (or the main PCB) or the module board (or the module PCB) may not only form a slim structure but also perform heat dissipation through a heat sink or a main housing made of a metal through a dissipation metal structure attached to the rear surface of the O-SIP instead of the main board (or the main PCB), thereby preventing performance degradation.

In addition, in this invention, an optical module obtained by combining an O-SIP provided with both a light emitting device and a light receiving device to a main board (or a main PCB) or a module board (or a module PCB) may be combined with a case with an infrared radiation (IR) window to provide a simple and slim proximity sensor.

### BRIEF DESCRIPTION OF THE DRAWINGS

FIG. 1 is a cross-sectional view illustrating a package in which a photonic integrated circuit (IC) using a light emitting device and an electronic IC are embedded in an optical system-in-package (O-SIP) using semiconductor packaging according to a first embodiment of the present invention.
FIG. 2 is a cross-sectional view of a modified example in which a partial or entire opening is formed in a redistribution layer in an O-SIP using semiconductor packaging according to the first embodiment of the present invention.
FIG. 3 is a cross-sectional view illustrating a package in which a photonic IC using a light emitting device and a plurality of electronic ICs are embedded in an O-SIP using semiconductor packaging according to a second embodiment of the present invention.
FIG. 4 is a cross-sectional view illustrating a package in which a photonic IC using a light emitting device and a light receiving device and an electronic IC are embedded in an O-SIP using semiconductor packaging according to a third embodiment of the present invention.
FIG. 5 is a cross-sectional view illustrating a package in which a transmitter optical sub-assembly (TOSA) and a receiver optical sub-assembly (ROSA) are separately formed and a heat dissipation metal structure is stacked in an O-SIP using semiconductor packaging according to a fourth embodiment of the present invention.
FIG. 6 is a cross-sectional view illustrating an optical module in which an O-SIP according to the first embodiment is mounted in a main PCB according to a fifth embodiment of the present invention.
FIG. 7 is a cross-sectional view illustrating an optical module in which an O-SIP according to the first embodiment and an optical component are mounted in a main PCB according to a sixth embodiment of the present invention.
FIG. 8 is a cross-sectional view illustrating an optical transceiver manufactured using an optical module according to the sixth embodiment of the present invention.
FIG. 9 is a cross-sectional view illustrating an optical module in which an O-SIP according to the first embodiment is mounted in a main PCB according to a seventh embodiment of the present invention.
FIGS. 10A to 10C are a top perspective view, a rear perspective view, and a rear view, , respectively, of an optical module for a single mode detachable optical transceiver according to the seventh embodiment of the present invention, and FIG. 10D is a cross-sectional view taken along an A-A line of FIG. 10C.
FIG. 11 is a partially enlarged cross-sectional view of the optical module shown in FIG. 10C.
FIGS. 12A to 12C respectively show a proximity sensor according to an eighth embodiment of the present invention, and are a plan view of an O-SIP chip for a proximity sensor, a perspective view of an example in which an O-SIP chip for a proximity sensor is mounted on a sensor PCB, and a cross-sectional view of the structure of the proximity sensor.

### BEST MODE FOR CARRYING OUT THE INVENTION

Hereinafter, embodiments of the present invention will be described in detail with reference to the accompanying drawings.

The sizes and shapes of the components shown in the drawings may be exaggerated for clarity and convenience. In addition, terms defined in consideration of the configuration and operation of the present invention may vary depending on the intention or custom of the user, the operator, and the like. Definitions of these terms should be based on the content of this specification.

In general, semiconductor packages are required to play four major roles: mechanical protection, electrical connection, mechanical connection, and heat dissipation.

Semiconductor packages cover semiconductor chips/devices with package materials such as epoxy mold compound (EMC) to protect the semiconductor chips/devices from external mechanical and chemical impacts.

Each semiconductor package serves to connect a physically/electrically molded chip to a system. Electrically, it is necessary to connect a chip with a system to supply power to the chip, and create a passage through which signals may be input or output so that desired functions may be performed. In addition, the chip should be well connected so as to be well attached to the system while the chip is being used.

At the same time, heat generated in the chip/device should be rapidly dissipated. When a semiconductor product operates, current flows, and when current flows, resistance is inevitably generated and heat is generated accordingly.

A semiconductor package completely surrounds a chip, and if the semiconductor package does not dissipate heat well, the chip may be overheated and the temperature of the device or chip molded inside may rise above an operating temperature, eventually stopping the operation of the device or chip. Therefore, it is essential that semiconductor packages should effectively dissipate heat. As semiconductor products become faster and more functional, the importance of the cooling role of packages is increasing.

System-in-Package (SIP) is configured to have one independent function by stacking or arranging multiple chips in one package. Typically, a SIP includes all parts as a complete system consisting of signal processing devices such as microprocessors and multiple chips containing multiple memories.

The present invention relates to an O-SIP provided on an optical transceiver, etc., which may be mounted on a main PCB to form an optical module, and the optical module may be embedded in the optical transceiver.

The main PCB may include a laser diode driver (LDD) and a clock data recovery (CDR) for a transmitter optical sub-assembly (TOSA), a transimpedance amplifier (TIA)/limiting amplifier (LA) for a receiver optical sub-assembly (ROSA), and a micro controller unit (MCU) for performing overall transmission and reception control of an optical transceiver, which are mounted on the main PCB.

The main PCB may include an analog-to-digital converter (ADC) and a digital-to-analog converter (DAC), to perform signal processing in a digital signal processing method by a microcontroller unit (MCU) and a field programmable gate array (FPGA), and may include a digital signal processor (DSP) and a driver to drive a TOSA and a ROSA. In addition, the main PCB may be configured in various ways.

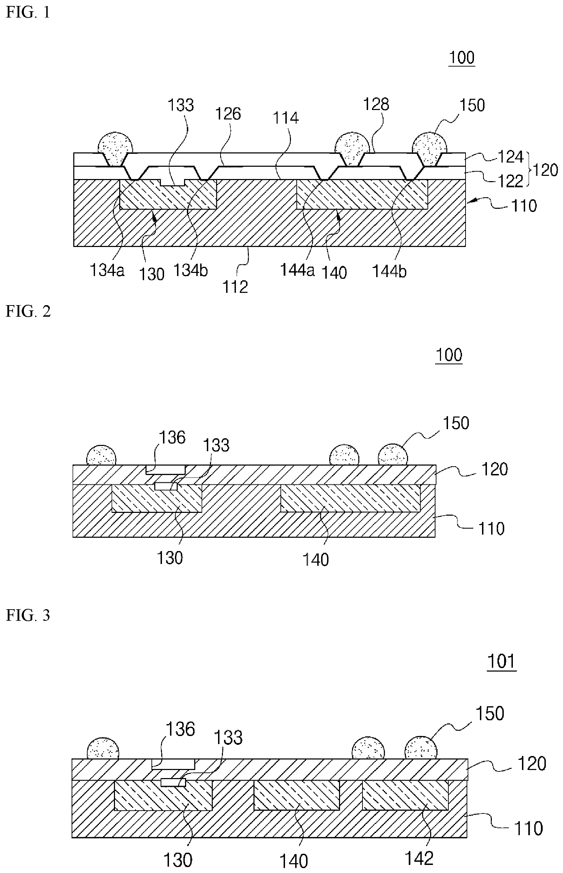

FIG. 1 is a cross-sectional view illustrating a package in which a photonic integrated circuit (IC) using a light emitting device and an electronic IC are embedded in an optical system-in-package (O-SIP) using semiconductor packaging according to a first embodiment of the present invention, and FIG. 2 is a cross-sectional view of a modified example in which a partial or entire opening is formed in a redistribution layer in an O-SIP using semiconductor packaging according to the first embodiment of the present invention.

Hereinafter, an O-SIP using a semiconductor packaging according to a first embodiment of the present invention will be described with reference to FIGS. 1 and 2.

The O-SIP 100 according to a first embodiment of the present invention includes a photonic IC 130 and an electronic IC 140 inside a mold body 110, and the mold body 110 has a first surface (or a lower surface) 112 and a second surface (or an upper surface) 114 that face each other and are flat. A redistribution layer (RDL) 120 including a plurality of terminal pads 150 for external connection of the package may be formed on the second surface (or the upper surface) 114 of the mold body 110.

The O-SIP 100 according to the first embodiment of the present invention may be implemented into a slim O-SIP 100 while completely solving a height tolerance due to a wiring between devices by packaging the photonic IC 130 and the electronic IC 140 by using a fan-out technology of pulling out input/output (I/O) terminals thereby increasing the I/O terminals, that is, a Fan-Out Wafer Level Package (FOWLP) technology, when the photonic IC 130 and the electronic IC 140 are integrated, without wire-bonding, by using a flip chip package technology, while the devices are integrated without using a substrate. The O-SIP 100 may miniaturize and slim at a level of 1/16 or so compared to a package of using a conventional PCB and reduce costs.

In the case of the O-SIP 100, the photonic IC 130 and the electronic IC 140 are integrated in a flip chip form without using a substrate such as a PCB as a kind of System-In-Package (SIP) technology, and, for example, the mold body 110 is formed by packaging the photonic IC 130 and the electronic IC 140 by using an encapsulation material such as an epoxy mold compound (EMC) for fixing a chip (die).

As a result, the mold body 110 serves to safely protect, from impact, an optical engine module, which is packaged after being integrated. The O-SIP 100 including the photonic IC 130 and the electronic IC 140 in the mold body 110 may constitute an optical engine module.

In addition, the O-SIP 100 may be obtained as a semiconductor package type, by performing a manufacturing process using a semiconductor process in units of wafers, then integrally forming a redistribution layer 120 including a plurality of terminal pads 150 on the second surface 114 of the package, and performing a dicing process that individually separates the O-SIP 100.

The photonic IC unit 130 and the electronic IC unit 140 are molded in a package, and terminal pads 150 each on which a solder ball for electrical connection is mounted, are arranged above the second surface 114 of the mold body 110, and the light entrance/exit part 133 is arranged on the second surface 114 of the mold body 110. The photonic IC 130 is an integrated circuit (IC) that performs optical processing, and serves to convert an optical signal into an electrical signal or an electrical signal into an optical signal.

For example, the photonic IC 130 may use a chip additionally including a light emitting device such as a VCSEL and a LD, a light receiving device such as a PD, an APD, a CIS, a CCD image sensor, and a ToF sensor, and a signal processing device as a circuit or IC that provides the light emitting device and the light receiving device with additional functionality or is responsible for signal processing.

In addition, the photonic IC 130 may include a planar lightwave circuit (PLC), in which a waveguide may be formed on a flat chip to perform functions such as a beam splitter, a modulator, a wavelength division multiplexing (WDM), and the like.

The electronic IC 140, which drives or interfaces the photonic IC 130, may include an IC for performing electrical signal processing, a function of receiving and amplifying/converting an electrical signal from the photonic IC 130, and the like, and may include a separated IC and an integrated IC that performs a LD driver IC, a CDR, an equalizer, a TIA, an I2C communication, a DSP, and the like.

In addition, the O-SIP 100 according to the first embodiment of this invention may further include devices having various functions such as memory, logic processor, and analog driver.

In this case, various materials including a semiconductor material such as GaAs, InGaAs, Si, SiN, Glass, Quartz, and SiON may be used as the device for the photonic IC 130, and various semiconductor materials such as Si, SiC, SiGe, and the like may be used as the device for the electronic IC 140. In order to mold the photonic IC 130 and the electronic IC 140, an encapsulation material such as an epoxy mold compound (EMC) and an epoxy resin may be used, and in a molding operation, several cells may be molded at a time at a wafer and panel level.

A redistribution layer 120 may be formed on the second surface (the upper surface) 114 of the mold body 110 formed by the encapsulation material, and the redistribution layer 120 may include terminal pads 150 for external connection of the package.

In order to form the insulating layer for the redistribution layer 120, various materials including polyimide (PI), poly (methylmethacrylate) (PMMA), benzocyclobutene (BCB), silicon oxide (SiO₂), acryl, and epoxy groups may be used, and a photo-lithography process may be used to form a wiring layer pattern.

In this case, the material of a wiring layer may serve as a photoresist (PR) capable of being developed, and the wiring layer may be etched after a PR coating is additionally performed. A process of depositing a metal is undergone after forming an insulating layer, and the metal used for the redistribution layer 120 may include various metal materials such as Cu, Al, Au, and Ag, or a compound thereof.

The redistribution layer 120 shown in FIG. 1 is connected in two stages: a first interconnection between the photonic IC 130 and the electronic IC 140 from respective bonding pads 134a and 134b, and bonding pads 144a and 144b of the photonic IC 130 and the electronic IC 140, exposed to the second surface 114 of the mold body 110; and simultaneously a second interconnection of the bonding pads 134a and 134b, the bonding pads 144a and 144b, to terminal pads 150 on the upper part of the package by using first and second connection wires 126 and 128 made of metal formed on first and second insulating layers 122 and 124, respectively, to form a plurality of fan-out type terminal pads 150 for connection with the outside of the O-SIP 100.

The external connection terminal pads 150 formed on the redistribution layer 120 may be manufactured by directly exposing a metal surface of the redistribution layer 120 to the outside, such as a land grid array (LGA) type, or mounting solder balls on an upper portion of the package, such as a ball grid array (BGA) type, as shown in FIG. 1.

In this case, since the redistribution layer 120 includes a laser diode for generating an optical signal and/or a photodiode for receiving an optical signal, in the photonic IC 130, the first and second insulating layers 122 and 124 may be made of a transparent material as shown in FIG. 1 such that an optical signal is generated from the laser diode or an optical signal is received by the photodiode.

In addition, when the first and second insulating layers 122 and 124 are formed of an opaque material, the redistribution layer 120 may partially or entirely include an opening 136 through which an optical signal generated from the photonic IC 130 may pass, as shown in FIG. 2.

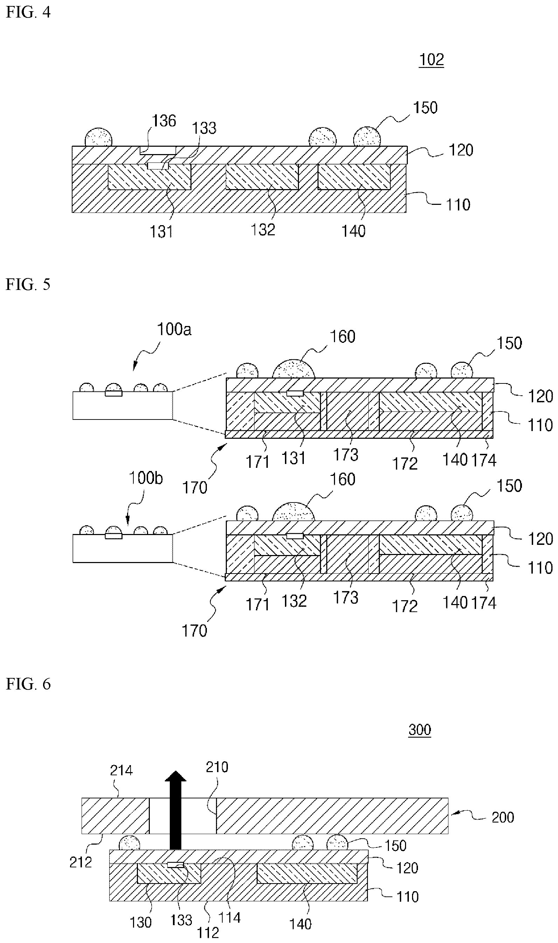

Furthermore, as illustrated in FIG. 5, the redistribution layer 120 may further include an optical lens 160 for changing (controlling) a path of light L generated from the photonic IC 130 even when the first and second insulating layers 122 and 124 include a transparent material.

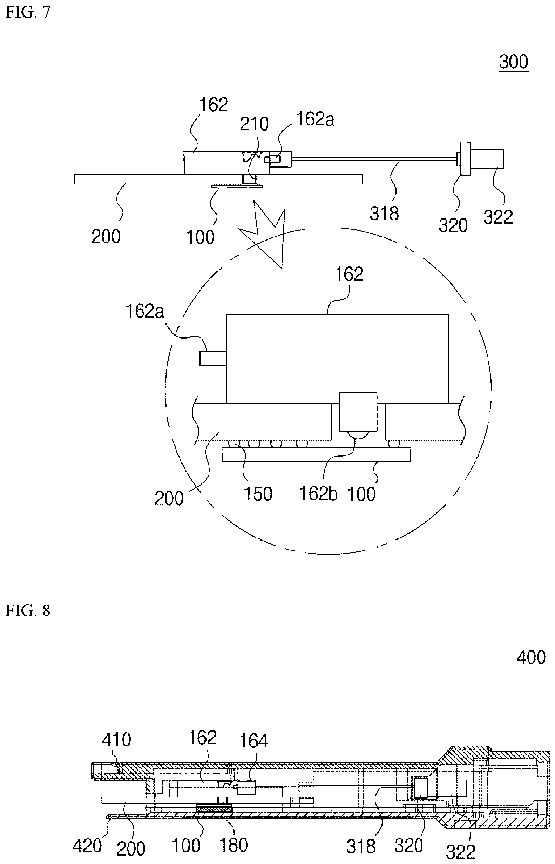

For example, the optical lens 160 functions as a collimating lens which makes the light L generated from the photonic IC 130 in a path in near parallel without being dispersed, or a focusing lens that focuses the light L at one point. Thus, the light L may be guided to be incident to an optical component 162 arranged in a PCB 200 of an optical module 300 shown in FIGS. 6 and 7, for example, a mirror or a lens.

As described above, the O-SIP 100 according to the first embodiment of the present invention may be implemented into an optical system-in-package (O-SIP) including the photonic IC 130 and the electronic IC 140 in the package to configure an optical engine module in a FOWLP method that does not use a via.

FIG. 3 is a cross-sectional view illustrating a package in which a photonic IC 130 using a light emitting device and a plurality of electronic ICs 140 are embedded in an O-SIP 101 using semiconductor packaging according to a second embodiment of the present invention.

Although the O-SIP 100 using the semiconductor packaging according to the first embodiment includes a single photonic IC 130 and a single electronic IC 140, an O-SIP 101 using semiconductor packaging according to a second embodiment of the present invention may include a package in which a single photonic IC 130 and a plurality of electronic ICs 140 and 142 are embedded.

In addition, as shown in FIG. 4, an O-SIP 102 using semiconductor packaging according to a third embodiment of this invention may simultaneously use a light emitting device 131 such as a VCSEL and a light receiving device 132 such as a PD as photonic ICs.

As described above, the O-SIP 102 according to the third embodiment of the present invention is formed such that the light emitting device 131 and the light receiving device 132 as photonic ICs are packaged together with the electronic IC 140, in the mold body 110. Accordingly, transmission and reception of an optical signal may be performed using a SIP package formed in the form of one semiconductor chip.

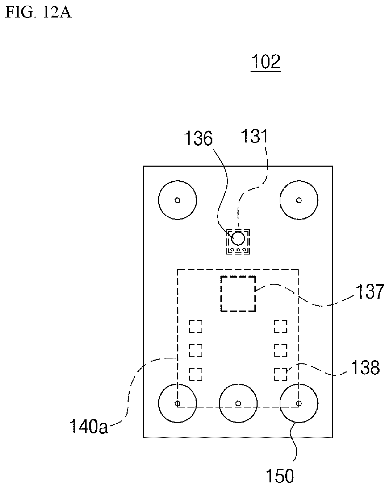

The O-SIP 102 according to the third embodiment of the present invention may be used in a proximity sensor 302 shown in FIGS. 12A to 12C, as described later.

FIG. 5 is a cross-sectional view illustrating a package in which a transmitter optical sub-assembly (TOSA) and a receiver optical sub-assembly (ROSA) are separately formed and a heat dissipation metal structure is stacked on a first surface (lower surface) in an O-SIP using semiconductor packaging according to a fourth embodiment of the present invention.

Referring to FIG. 5, an O-SIP according to a fourth embodiment of the present invention may be separately configured into a TOSA 100a and a ROSA 100b.

In this case, the O-SIP according to the fourth embodiment of the present invention employs the light emitting device 131, such as a VCSEL, as the photonic IC in the case of the TOSA 100a, and employs the light receiving device 132 such as a PD as the photonic IC in the case of the ROSA 100b.

That is, the TOSA 100a may employ the light emitting device 131 such as a VCSEL as a photonic IC 130, and employ a driving circuit for driving the light emitting device 131 as an electronic IC 140. The redistribution layer 120 may be formed on the second surface 114 of the mold body 110, and a heat dissipation device 170 may be provided on the first surface 112 of the mold body 110.

The heat dissipation device 170 may include first and second metal structures 171 and 172 for heat dissipation under the photonic IC 130 and the electronic IC 140, respectively.

The sizes of the first and second metal structures 171 and 172 may be greater or less than those of the photonic IC 130 and the electronic IC 140, respectively.

As a method of forming the first and second metal structures 171 and 172, metal pieces may be attached to lower portions of the photonic IC 130 and the electronic IC 140, respectively, and then a FOWLP process may be performed in a state in which the metal pieces are attached to the photonic IC 130 and the electronic IC 140. In this case, a variety of adhesives may be used to attach the photonic IC 130 and the electronic IC 140 to the metal pieces, which may use silver epoxy or epoxy, EMC, or carbon nanotube (CNT) compound. For the best heat dissipation performance and electrical conductivity, a conductive material such as silver epoxy may be used. In the present invention, a conductive material may also be used to apply an electrical signal to the lower surfaces of the photonic IC 130 and the electronic IC 140.

In addition, when connecting the photonic IC 130 and the electronic IC 140 with the redistribution layer 120, a conductive structure in the form of a via should be formed in a FOWLP. In the present invention, a third metal structure 173 is molded together with other photonic IC 130 and electronic IC 140 during a FOWLP by using a PCB including via or a Cu piece. Subsequently, after grinding and flattening the third metal structure 173 so that the upper and lower metals of the third metal structure 173 for via are exposed, a metal connection layer 174 may be formed by depositing a metal under the photonic IC 130 and the electronic IC 140, and a redistribution layer 120 may be formed on the photonic IC 130 and the electronic IC 140.

As a result, the first and second metal structures 171 and 172 may be electrically connected to the redistribution layer 120 through the third metal structure 173 for via to be wired. In this case, a metal may be deposited on the bottom of the wafer at a wafer level to be connected without a pattern, or a wiring layer may be formed on the opposite surface of the redistribution layer 120 of the FOWLP wafer so as to be connected to each other as a double-sided wiring layer.

In the present invention, the redistribution layer 120 may be electrically connected to the metal connection layer 174 through the third metal structure 173 for via to use the metal connection layer 174 as a ground, and the heat of the redistribution layer 120 may be easily dissipated to the first surface (or the lower surface) 112 through the third metal structure 173 for via.

The ROSA 100b may also employ a light receiving device 130b, such as a photodiode PD, as the photonic IC 130, and employ an IC that performs functions of receiving and amplifying/converting the electrical signal obtained from the light receiving device 130b as the electronic IC 140.

In addition, the redistribution layer 120 may be formed on the second surface 114 of the mold body 110, and the first and second metal structures 171 and 172 for heat dissipation may be formed on the first surface 112 of the mold body 110 for additional heat dissipation under the photonic IC 130 and the electronic IC 140.

Furthermore, the first and second metal structures 171 and 172 for heat dissipation may be electrically connected to the redistribution layer 120 through the third metal structure 173 for via to be wired.

The O-SIP according to the fourth embodiment of the present invention may be electrically connected to the redistribution layer 120 through the third metal structure 173 for via of wide width, thereby minimizing inductance.

Meanwhile, the O-SIP 100 according to the present invention includes the photonic IC 130 and the electronic IC 140 in the mold body 110, and the redistribution layer (RDL) 120 including a plurality of terminal pads 150 is formed on the second surface (or the upper surface) 114 of the mold body 110.

In this case, instead of forming the first and second metal structures 171 and 172 for heat dissipation, the O-SIP 100 according to the present invention may be flattened so that the lower surfaces of the photonic IC 130 and the electronic IC 140 are exposed by grinding the first surface (or the lower surface) 112 of the mold body 110.

As described above, when the lower surfaces of the photonic IC 130 and the electronic IC 140 are exposed, heat dissipation may be directly performed.

In addition, the TOSA 100a may be used when implementing a TOF sensor.

FIG. 6 is a cross-sectional view illustrating an optical module in which an O-SIP according to the first embodiment is mounted in a main PCB according to a fifth embodiment of the present invention.

Referring to FIG. 6, an optical module 300 according to a fifth embodiment of the present invention may be obtained by mounting the O-SIP 100 according to the first embodiment on the main PCB 200.

For example, the O-SIP 100 according to the first embodiment may be formed by employing a light emitting device such as a VCSEL or a light receiving device such as a PD to the inside of the mold body 110, embedding the electronic IC 140, forming the redistribution layer 120 on the second surface 114 of the mold body 110, and forming the terminal pads 150 on the redistribution layer 120 using solder balls.

The O-SIP 100 having the structure described above may be mounted on the first surface (or the lower surface) 212 of the main PCB 200 by using solder balls of the terminal pads 150, and in this case, a surface mount technology (SMT) method may be used. In this case, various electronic components required to control transmission and reception of optical signals as optical modules 300 are mounted on the second surface (or the upper surface) 214 of the main PCB 200.

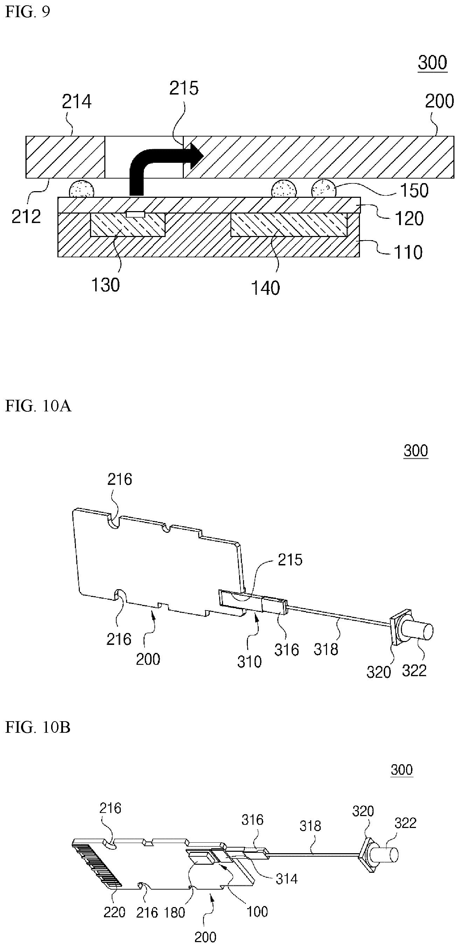

After the O-SIP 100 package device is mounted on the first surface (or the lower surface) 212 of the main PCB 200, an optical path entering and exiting the light entrance/exit part 133 of the photonic IC 130 of the O-SIP 100 package device may be formed inside the main PCB 200. In this case, an optical path may be formed by penetrating the main PCB 200 as shown in FIG. 6 or by making some grooves in the main PCB 200 as shown in FIG. 9.

As shown in FIG. 6, a light passing window 210 may be formed by processing a through hole in the main PCB 200 to form an optical path, or a portion or an entire surface of the PCB may include a transparent material to form an optical path. The main PCB 200 may include a wiring pattern formed on Si or glass.

FIG. 7 is a cross-sectional view illustrating an optical module in which an O-SIP according to the first embodiment and an optical component are mounted in a main PCB according to a sixth embodiment of the present invention.

Referring to FIG. 7, an optical module 300 according to a sixth embodiment of the present invention may have a structure obtained by mounting the O-SIP 100 according to the first embodiment and an optical component 162 on the main PCB 200.

The optical module 300 may use the optical component 162 for connection with an optical fiber 318 inside an optical transceiver 400 shown in FIG. 8. In this case, the optical component 162 may be made of a plastic injection-molded product, and may include a reflective surface that bends an optical path by 90 degrees from vertically to horizontally, and two lenses of a primary collimation lens 162b for making the incident light into parallel light to go straight without spreading, and a second focusing lens for focusing incident light.

In addition, when an optical path of light emitted from the photonic IC 130 of the O-SIP 100 manufactured by the FOWLP method passes through the main PCB 200, the optical path becomes long. Accordingly, a part of the structure of the lens is inserted into the light passing window 210 of the main PCB 200, thereby reducing a distance between the primary collimation lens 162b and the photonic IC 130 of the O-SIP 100, to thus prevent the spread of light. A coupling protrusion 162a is provided on the opposite surface of the primary collimation lens 162b, an optical fiber block 164 is physically coupled to the coupling protrusion 162a, and an optical cable connector including a LC receptacle 320 may be connected to the optical fiber block 164 through a pigtail fiber 318. In addition, a socket coupling part 322 to which a plug of an optical cable (not shown) is coupled protrudes from the front end portion of the LC receptacle 320.

FIG. 8 is a cross-sectional view illustrating an optical transceiver manufactured using an optical module according to the sixth embodiment of the present invention.

FIG. 8 shows an example of manufacturing an optical transceiver 400 or an active optical cable (AOC) manufactured by assembling an optical module 300, which is obtained using an O-SIP 100, inside a housing including an upper housing 410 and a lower housing 420. In this case, the rear end portion of the optical transceiver 400 is connected to a main body such as a one-side terminal, and a connector of an optical cable is coupled to the front end portion of the optical transceiver 400.

In the optical transceiver 400, the TOSA 100a and the ROSA 100b of the optical module 300 of FIG. 7 or the O-SIP according to the fifth embodiment shown in FIG. 5 may be applied on the main PCB 200.

In this case, a thermal interface material (TIM) 180 may be inserted between a lower housing 420 made of metal of the optical transceiver for heat dissipation and the metal connection layer 174 for heat dissipation of the O-SIP 100 to perform heat dissipation.

Through this heat dissipation structure, thermal resistance may be greatly reduced by removing the main PCB 200 from the path from the chip of the photonic IC 130 and electronic IC 140 to the metal housing 420 inside the O-SIP 100 package.

In the optical transceiver 400 of FIG. 8, a VCSEL may be used as the photonic IC 130 molded in the package of the O-SIP 100. In this case, the O-SIP 100 may be used as an optical engine module for a transmitter TX of the optical transceiver 400 that connects short distances within 100 m to 300 m through a multi-mode optical fiber 318.

In addition, when a PD is used as the photonic IC 130 inside the O-SIP 100, the O-SIP 100 may be used as an optical engine module for a receiver RX of the optical transceiver 400.

As will be described later, when there is a structure that may transmit an optical signal inside the main PCB or on the surface of the main PCB, the optical signal may be transmitted (connected) to the optical structure (or the optical device) on the main PCB without penetrating the optical signal through the main PCB.

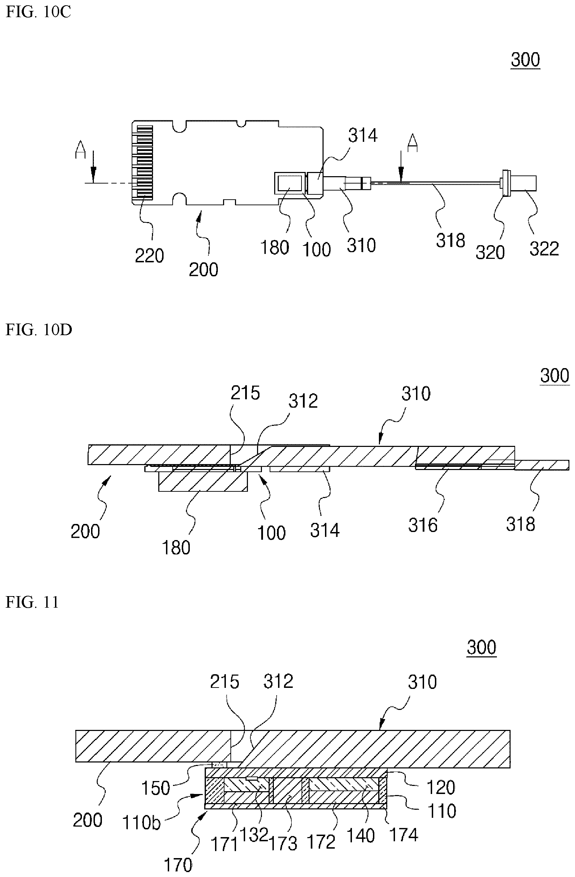

FIG. 9 is a cross-sectional view illustrating an optical module in which an O-SIP according to the first embodiment is mounted in a main PCB according to a seventh embodiment of the present invention. FIGS. 10A to 10C are a top perspective view, a rear perspective view, and a rear view, , respectively, of an optical module for a single mode detachable optical transceiver according to the seventh embodiment of the present invention, and FIG. 10D is a cross-sectional view taken along an A-A line of FIG. 10C. FIG. 11 is a partially enlarged cross-sectional view of the optical module shown in FIG. 10C.

Referring to FIGS. 9 to 11, an optical module according to a seventh embodiment of the present invention having a structure capable of transmitting an optical signal to the inside of the main PCB or on the surface of the main PCB will be described below.

In the optical module 300 according to the seventh embodiment, an AWG 310 and an O-SIP 100 should be arranged close so as not to use an additional lens between the AWG 310 and the O-SIP 100.

To this end, the optical module 300 according to the seventh embodiment of the present invention has a structure in which the O-SIP 100 according to the first embodiment is mounted on the main PCB 200, and the AWG 310 is inserted into a coupling groove 215 of the main PCB 200.

Referring to FIGS. 10A to 10D, the optical module 300 according to the seventh embodiment is provided with a slot-shaped coupling groove 215 capable of receiving the front end portion of the AWG 310 on one side surface of the main PCB 200, and is mounted on the first surface (or the lower surface) 212 of the main PCB 200 so that the light entrance/exit part 132 of the photonic IC 130 of the O-SIP 100 is matched with the coupling groove 215. An external connection terminal 220 connected to a main body such as a one-side terminal is provided at the rear end portion of the first surface (or the lower surface) 212 of the main PCB 200.

Subsequently, after inserting the front end portion of the AWG 310 into the coupling groove 215, an AWG support 314 is installed on the rear surface of the main PCB 200 to fix the front end portion of the AWG 310 to the main PCB 200.

The AWG 310 may be connected to an optical cable connector including a LC receptacle 320 through a ferrule 316 and a pigtail optical fiber 318 connected thereto, at the rear end portion thereof. In addition, a socket coupling part 322 to which a plug of an optical cable (not shown) is coupled protrudes from the front end portion of the LC receptacle 320.

The optical module 300 according to the seventh embodiment may be assembled in the housing for the optical transceiver shown in FIG. 8 to constitute an optical transceiver 400.

In addition, a TIM 180 may be inserted between a housing 420 made of metal and the metal connection layer 174 for heat dissipation of the O-SIP 100 on the first surface of the O-SIP 100 to perform heat dissipation.

Referring to FIG. 11, the optical module 300 for a single-mode detachable optical transceiver according to the present invention may employ the ROSA 100b shown in FIG. 5.

As shown in FIGS. 10A to 10D, the optical module 300 has a structure in which the O-SIP 100 has one of the TOSA 100a and the ROSA 100b coupled to the lower part of the main PCB 200 and the AWG 310 coupled to the coupling groove 215 formed on one side surface.

First, when the TOSA 100a is applied to the optical module 300, the AWG 310 serves to perform a wavelength division multiplexing (WDM) function of optical signals generated from a light emitting device such as a VCSEL as the photonic IC 130 of the TOSA 100a, for example, 4-channel optical signals, and transmit the optical signals having undergone the WDM function to the optical fiber 318.

The AWG 310 may include, for example, an optical multiplexer unit performing an optical multiplexing function, a plurality of input waveguides connected to a front end portion of the optical multiplexer unit to receive a plurality of optical signals incident from a plurality of light emitting devices, and a single mode output waveguide connected to a rear end portion of the optical multiplexer unit to output one optical signal output after the plurality of optical signals have been multiplexed.

In this case, the AWG 310 is processed to have an end facing the photonic IC 130 processed into an angled inclined surface 312 so that four channels of optical signals generated from four light emitting devices are bent vertically at the end of the AWG 310 so as to be incident through the four input waveguides of the AWG 310. A total reflection refraction occurs in the inclined surface 312 exposed in the air of the AWG 310.

Accordingly, the optical module 300 for optical transmission may realize a wavelength multiplexer (WDM MUX) of 25 Gbps per channel (that is, 25 Gbps x 4 channels = 100 Gbps). In addition, the optical module 100 for optical transmission may realize a wavelength multiplexer (WDM MUX) having 100 Gbps per channel (=10 Gbps×10 channels).

FIG. 11 is a cross-sectional view of an embodiment in which an optical module 300 for optical reception for an optical transceiver using a WDM is formed by using an O-SIP and an AWG according to an embodiment of the present invention.

Referring to FIG. 11, when the ROSA 100b is applied to the optical module 300, a light receiving device 132 such as a PD is used as a photonic IC of the ROSA 100b.

The AWG 310 may perform a demultiplexing operation (De-MUX) of various wavelengths using a PLC. In this case, the end of the rear end portion of the AWG 310 is processed into an angled inclined surface 312 so that light may be bent at the end of the AWG 310 and emitted in a vertical direction.

The optical signals, which have been demultiplexed, bent on the inclined surface 312 of the AWG 310 and emitted in a vertical direction are incident on the light receiving device 132 such as a PD of the ROSA 100b and are converted into electric signals.

FIGS. 12A to 12C respectively show a proximity sensor according to an eighth embodiment of the present invention, and are a plan view of an O-SIP chip for a proximity sensor, a perspective view of an example in which an O-SIP chip for a proximity sensor is mounted on a sensor PCB, and a cross-sectional view of the structure of the proximity sensor.

Referring to FIG. 12A, a chip of an O-SIP 102 for a proximity sensor includes a light emitting device 131 such as an IR LED emitting infrared (IR) light as a photonic IC, and a proximity sensor IC 140a having a light receiving function by driving the light emitting device 131 and embedding a light receiving device 132 such as a PD.

The light emitting device 131 and the light receiving device 132 includes light entrance/exit parts 133 and 137 at upper portions thereof, respectively, and a chip of the proximity sensor IC 140a includes a plurality of terminal pads 138. As a chip of the O-SIP 102 is packaged in the form of a FOWLP, a plurality of terminal pads 150, each of which has solder balls attached to the surface of the redistribution layer 120 are arranged at the outer periphery of the package so as to be connected to the plurality of terminal pads 138 on the surface of the O-SIP 102.

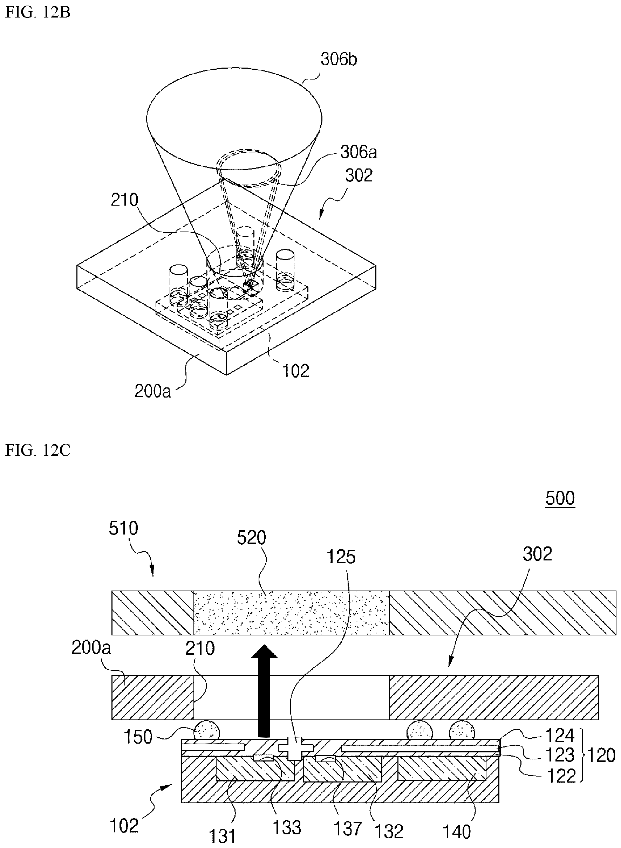

Referring to FIG. 12B, the optical proximity sensor 302 according to an embodiment of the present invention includes a sensor PCB 200a having an O-SIP 102 and a through hole 210, and a chip of the O-SIP 102 for a proximity sensor is mounted on a lower portion of the sensor PCB 200a.

FIG. 12B shows a light emitting area cone 306a showing an angle of an area where infrared (IR) light is emitted from the light emitting device 131, and a light receiving area cone 306b indicating an angle of an area where the infrared (IR) light is emitted and the IR light reflected and returned from a target is received by the light receiving device 132 through the through hole 210. In this case, it may be seen that the light emitting area cone 306a is included in the light receiving area cone 306b.

Referring to FIG. 12C, the optical proximity sensor 302 according to an embodiment of the present invention includes a sensor PCB 200a having an O-SIP 102 and a through hole 210, and the optical proximity sensor 302 may be coupled to a portion where an infrared radiation window 520 is formed in a portion of a housing 510 of the main body such as a terminal 500, which corresponds to the through hole 210.

The basic structure of the O-SIP 102 used in the optical proximity sensor 302 is the same as the structure shown in FIG. 4.

That is, the O-SIP 102 includes a light emitting device 131 such as an IR LED emitting infrared (IR) light as a photonic IC, and a proximity sensor IC 140a having a function of receiving light by driving the light emitting device 131 and embedding a light receiving device 132 such as a PD. The proximity sensor IC 140a may include a signal processing circuit capable of setting an operation condition of a sensor, determining whether the sensor is accessed, and communicating with the outside.

The light receiving device 132 may be embedded in the proximity sensor IC 140a, but FIG. 12C illustrates a case in which the light receiving device 132 and the proximity sensor IC 140a are separated from each other.

In addition, a light interference blocking layer 125 between the light emitting device 131 and the light receiving device 132, to prevent interference between the emitted light and the received light may be implemented using a metal capable of blocking the passage of light, when a connection wiring 123 is formed between the first and second insulating layers 122 and 124 of the redistribution layer 120.

The light entrance/exit parts 133 and 137 of the light emitting device 131 and the light receiving device 132 of the O-SIP 102, respectively, face the second surface 114 on which the terminal pads 150 of the O-SIP 102 are arranged.

Therefore, when the O-SIP 102 for the proximity sensor is mounted on the sensor PCB 200a, the sensor PCB 200a forms a through hole 210 in a portion facing the light entrance/exit parts 136 and 137 to form a path of light in the sensor PCB 200a. Accordingly, after infrared (IR) light is emitted from the light emitting device 131 of the proximity sensor 302, infrared light reflected and returned from the target is incident on the light receiving device 132 through the through hole 210 to allow the light to be emitted and emitted. The through hole 210 of the sensor PCB 200a should be formed on the ground that does not interfere with a desired divergence angle and a desired light reception angle of the infrared (IR) light.

The optical proximity sensor 302 according to an embodiment of the present invention may be implemented in a slim structure because a proximity sensor IC 140a for driving or interfacing the light emitting device 131 and the light receiving device 132 is included in the package.

While the present invention has been particularly shown and described with reference to exemplary embodiments thereof, by way of illustration and example only, it is clearly understood that the present invention is not to be construed as limiting the present invention, and various changes and modifications may be made by those skilled in the art within the protective scope of the invention without departing off the spirit of the present invention.

### INDUSTRIAL APPLICABILITY

The optical system-in-package (O-SIP) of the present invention includes a photonic IC and an electronic IC in a package using an optical FOWLP that does not use a conductive via, and may be applied to optical modules and optical transceivers by using the O-SIP.

The present invention is directed to a method of implementing an O-SIP for integrating and packaging of systems using optical devices. Thus, the present invention may be used in various ways in the optical communication and optical sensor industries. For optical communication, communication between servers inside a data center, and optical transceivers for 5G and 6G communication networks may be used.

In addition, since miniaturization and integration are implemented in a package in the case of the present invention, the present invention may also be used for on-board optical communication and chip-to-chip optical communication. Moreover, the present invention may also be used for transmission of high-capacity audio and video data between TVs or electronic boards, and set-top boxes.

In addition, the present invention may be used in an application in which it is important to reduce the size of a module such as a wireless earphone, a smart phone, or the like through implementation of a proximity sensor having a low profile.

## Claims

1. An optical system-in-package (O-SIP) comprising:
a mold body having a first surface and a second surface which are flat on a lower portion and an upper portion of the mold body, respectively;
a photonic integrated circuit (IC) molded inside the mold body to expose a bonding pad on the second surface;
an electronic IC molded to be spaced apart from the photonic IC inside the mold body to expose the bonding pad on the second surface; and
a redistribution layer (RDL) formed on the second surface of the mold body and having a plurality of fan-out terminal pads electrically connected to the outside while interconnecting the photonic IC and the electronic IC.

2. The O-SIP of claim 1, wherein the photonic IC comprises at least one of a light emitting device, a light receiving device, a chip that provides an additional function to the light emitting device or the light receiving device or is in charge of signal processing, and a planar lightwave circuit (PLC).

3. The O-SIP of claim 2, wherein the electronic IC comprises one of a driving circuit for driving the light emitting device, a circuit that receives and amplifies and/or converts an electrical signal from the light receiving device, a laser diode (LD) driver IC, a clock data recovery (CDR), an equalizer, a transimpedance amplifier (TIA), an inter-integrated circuit (I2C) communication, and a Digital Signal Processing (DSP).

4. The O-SIP of claim 1, further comprising first and second metal structures for heat dissipation, in which upper surfaces of the first and second metal structures are bonded to lower portions of the photonic IC and the electronic IC and lower surfaces thereof are exposed, respectively.

5. The O-SIP of claim 4, further comprising:
a third metal structure for a via that is inserted through the mold body between the photonic IC and the electronic IC, has an upper end connected to the RDL and a lower end portion exposed; and
a metal connection layer that connects the RDL to the lower portions of the photonic IC and the electronic IC and has a lower surface of the metal connection layer exposed by interconnecting the lower surfaces of the first to third metal structures.

6. The O-SIP of claim 4, further comprising a thermal interface material (TIM) installed on a lower portion of the metal connection layer to form a heat dissipation path to a metal housing of the main body.

7. The O-SIP of claim 1, wherein a transmitter optical sub-assembly (TOSA) to which a light emitting device is applied as the photonic IC and a receiver optical sub-assembly (ROSA) to which a light receiving device is applied as the photonic IC are formed in the O-SIP.

8. The O-SIP of claim 1, wherein the photonic IC comprises a light entrance/exit part on the second surface, and further comprises a metasurface that serves as a microlens or a metalens formed through a microelectro mechanical system (MEMS) or an imprint process on the RDL located above the light entrance/exit part.

9. An optical module comprising:
an optical system-in-package (O-SIP) for generating an optical signal or receiving an optical signal, in which a photonic integrated circuit (IC) and an electronic IC for driving or interfacing the photonic IC are molded inside a mold body having a first surface and a second surface which are flat, on a lower portion and an upper portion of the mold body; and
a printed circuit board (PCB) in which the O-SIP is mounted on a lower surface of the PCB and multiple electronic components are mounted on an upper surface thereof to control transmission and reception of the O-SIP, wherein
the PCB comprises a through hole forming an optical path when generating or receiving an optical signal in a vertical direction from or to the photonic IC in a portion corresponding to a light entrance/exit part of the photonic IC.

10. The optical module of claim 9, further comprising a redistribution layer (RDL) having a plurality of fan-out terminal pads for electrically connecting the photonic IC and the electronic IC to the outside while interconnecting the photonic IC and the electronic IC on the second surface in which a light entrance/exit part of the photonic IC is arranged.

11. The optical module of claim 9, further comprising an optical component positioned above the through hole of the PCB to bend the optical path 90 degrees from vertically to horizontally to transmit the optical signal between an optical fiber and the photonic IC, wherein the optical component is connected to an optical cable connector including a Lucent connector (LC) receptacle through the optical fiber.

12. An optical module comprising:
an optical system-in-package (O-SIP) for generating an optical signal or receiving an optical signal, in which a photonic integrated circuit (IC) and an electronic IC for driving or interfacing the photonic IC are molded inside a mold body having a first surface and a second surface which are flat, on a lower portion and an upper portion of the mold body;
a printed circuit board (PCB) in which the O-SIP is mounted on a lower surface of the PCB, multiple electronic components are mounted on an upper surface thereof to control transmission and reception of the O-SIP, and a slot-shaped coupling groove is provided on a side surface thereof; and
an arrayed waveguide grating (AWG), including a tip portion having an inclined surface, which is coupled with an end portion of the coupling groove, the AWG performing, when optical signals of a plurality of channels generated from the photonic IC are received, a wavelength division multiplexing (WDM) function to transmit the received optical signals to an optical fiber or de-multiplexing an optical signal received from the optical fiber to transmit the demultiplexed optical signals to the photonic IC through the inclined surface.

13. The optical module of claim 12, wherein the rear end portion of the AWG is connected to an optical cable connector including a Lucent connector (LC) receptacle through a ferrule and the optical fiber.

14. The optical module of claim 12, wherein the O-SIP comprises:
the mold body having a first surface and a second surface which are flat on a lower portion and an upper portion of the mold body, respectively;
the photonic integrated circuit (IC) molded inside the mold body to expose a bonding pad on the first surface;
the electronic IC molded to be spaced apart from the photonic IC inside the mold body to expose the bonding pad on the first surface; and
a redistribution layer (RDL) formed on the second surface of the mold body and having a plurality of fan-out terminal pads electrically connected to the outside while interconnecting the photonic IC and the electronic IC.

15. An optical transceiver comprising:
an optical module; and
a housing for accommodating the optical module, wherein the optical module is the optical module according to claim 9 or 12.
